# EUROPEAN PATENT APPLICATION

(11) **EP 4 300 551 A2**
(43) Date of publication of application: **03.01.2024**
(21) Application number: 23169683.2
(22) Date of filing: 25.04.2023
(51) Int. Cl.: H01L 21/48, H01L 23/498, H05K 1/11

(54) **ALIGNMENT VIA-PAD AND VIA-PLANE STRUCTURES**

(30) Priority: 01.07.2022 US 202217856185
(71) Applicant: Intel Corporation, Santa Clara, CA 95054 (US)
(72) Inventor: Strong, Veronica, Hillsboro 97123 (US); ALEKSOV, Aleksandar, Chandler 85286 (US)
(74) Representative: Goddar, Heinz J.

(57) **Abstract**

Disclosed herein are via-trace-via structures with improved alignment, and related devices and methods. For example, in some embodiments, an integrated circuit (IC) package support may include a conductive structure having an aperture; a conductive via at least partially nested in the aperture in the conductive structure; and a conductive bridge spanning between and in contact with the conductive structure and the conductive via. In some embodiments, the conductive structure is a conductive pad. In some embodiments, the conductive structure is a conductive plane.

## Description

### Background

Integrated circuit (IC) packages may include one or more dies or other components mounted to a package support. The package support may include conductive pathways through which power, ground, and/or signals may be transmitted.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a top view of an example via-pad structure, in accordance with various embodiments.
FIG. 1B is a side, cross-sectional view along the A-A' line of the example via-pad structure of FIG. 1A, in accordance with various embodiments.
FIG. 1C is a side, cross-sectional view along the B-B' line of the example via-pad structure of FIG. 1A, in accordance with various embodiments.
FIGS. 2A and 2B are top views of other example via-pad structures, in accordance with various embodiments.
FIG. 2C is a side, cross-sectional view along the C-C' line of the example via-pad structures of FIGS. 2A and 2B, in accordance with various embodiments.
FIG. 2D is a side, cross-sectional view along the D-D' line of the example via-pad structures of FIGS. 2A and 2B, in accordance with various embodiments.
FIG. 3A is a top view of an example via-plane structure, in accordance with various embodiments.
FIG. 3B is a side, cross-sectional view along the E-E' line of the example via-plane structure of FIG. 3A, in accordance with various embodiments.
FIG. 3C is a side, cross-sectional view along the F-F' line of the example via-plane structure of FIG. 3A, in accordance with various embodiments.
FIG. 3D is a side, cross-sectional view along the G-G' line of the example via-plane structure of FIG. 3A, in accordance with various embodiments.
FIG. 4 is a side, cross-sectional view of an example microelectronic assembly including a via-pad structure and/or a via plane structure, in accordance with various embodiments.
FIGS. 5A and 5B, 6A and 6B, 7A and 7B, 8A and 8B, 9A and 9B, 10A and 10B, 11A and 11B, and 12A and 12B are side, cross-sectional views of various stages in an example process for manufacturing a via-pad structure or a via-plane structure, in accordance with various embodiments.
FIG. 13 is a flow diagram of a method of manufacturing a via-pad structure or a via-plane structure, in accordance with various embodiments.
FIG. 14 is a top view of a wafer and dies that may be included in a package along with via-pad and/or via-plane structures, in accordance with any of the embodiments disclosed herein.
FIG. 15 is a side, cross-sectional view of an integrated circuit (IC) device that may be included in a package along with via-pad and/or via-plane structures, in accordance with any of the embodiments disclosed herein.
FIG. 16 is a side, cross-sectional view of an IC package that may include via-pad and/or via-plane structures, in accordance with various embodiments.
FIG. 17 is a side, cross-sectional view of an IC device assembly that may include via-pad and/or via-plane structures, in accordance with any of the embodiments disclosed herein.
FIG. 18 is a block diagram of an example electrical device that may include via-pad and/or via-plane structures, in accordance with any of the embodiments disclosed herein.

### Detailed Description

Disclosed herein are via-pad and via-plane structures with improved alignment in integrated circuit (IC) package supports, as well as related methods and devices. For example, in some embodiments, an IC package support (e.g., a package substrate or an interposer) may include a conductive structure having an aperture; a conductive via at least partially nested in the aperture in the conductive structure; and a conductive bridge spanning between and in contact with the conductive structure and the conductive via. In some embodiments, the conductive structure is a conductive pad. In some embodiments, the conductive structure is a conductive plane.

Conventional package substrate manufacturing techniques typically require multiple lithography exposure process steps (i.e., multiple masks) to fabricate via-on-pad and via-on-plane structures. Lithographic techniques that involve multiple masks or drilling layouts to pattern different features are subject to limitations on how accurately these different masks or drilling layouts can be aligned or overlaid with each other, and thus feature sizes have been required to be large enough to accommodate these alignment errors. The structures and techniques disclosed herein enable the formation of smaller and better-aligned features (e.g., via-pad and via-plane structures) in package substrates and other integrated circuit (IC) components using a single lithography exposure process. Some of these embodiments may utilize standard package substrate lithography tools and commercially available materials, while achieving these benefits. Further, various ones of the manufacturing processes disclosed herein may be less expensive and/or less complex than conventional techniques, while also achieving improved results.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "package" and an "IC package" are synonymous, as are a "die" and an "IC die." The terms "top" and "bottom" may be used herein to explain various features of the drawings, but these terms are simply for ease of discussion, and do not imply a desired or required orientation. As used herein, the term "insulating" may mean "electrically insulating," unless otherwise specified.

When used to describe a range of dimensions, the phrase "between X and Y" represents a range that includes X and Y. The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

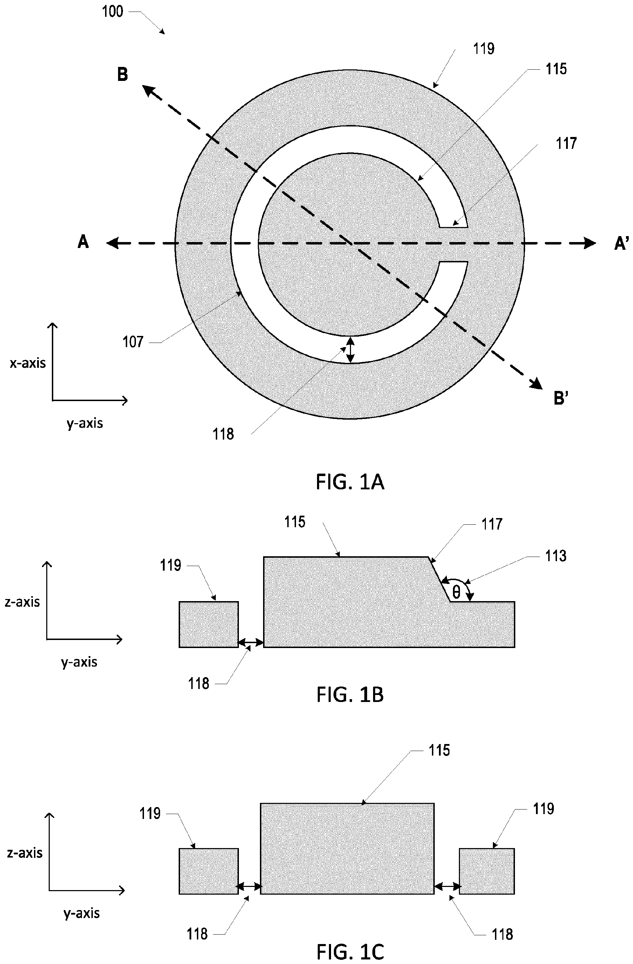

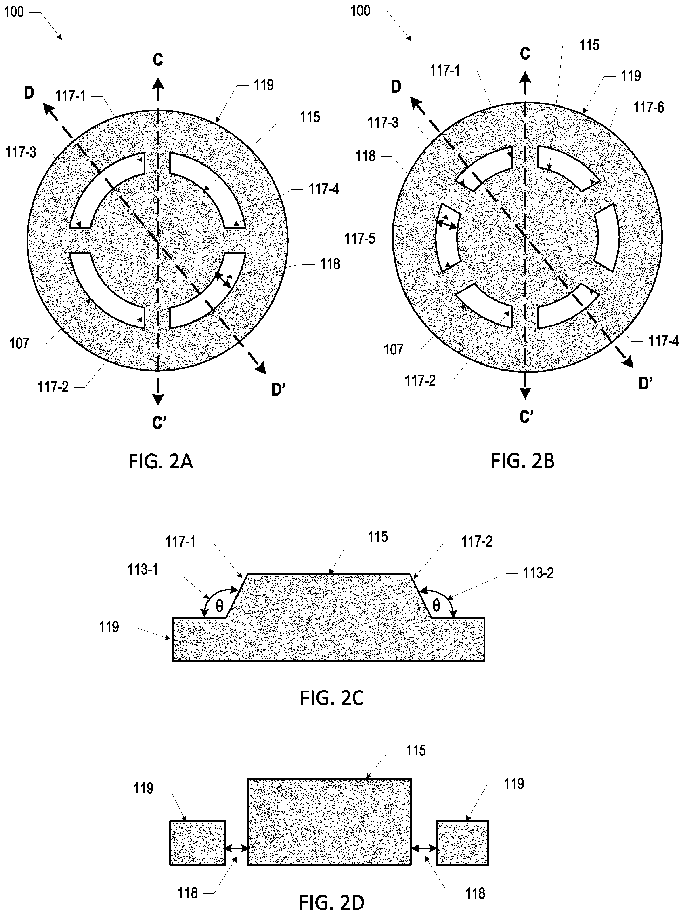

For convenience, the phrase "FIG. 1" may be used to refer to the collection of drawings of FIGS. 1A-1C, the phrase "FIG. 2" may be used to refer to the collection of drawings of FIGS. 2A-2D, etc. Although certain elements may be referred to in the singular herein, such elements may include multiple sub-elements. For example, "an insulating material" may include one or more insulating materials. As used herein, a "conductive contact" may refer to a portion of conductive material (e.g., metal) serving as an electrical interface between different components; conductive contacts may be recessed in, flush with, or extending away from a surface of a component, and may take any suitable form (e.g., a conductive pad or socket, or portion of a conductive line or via).

An "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

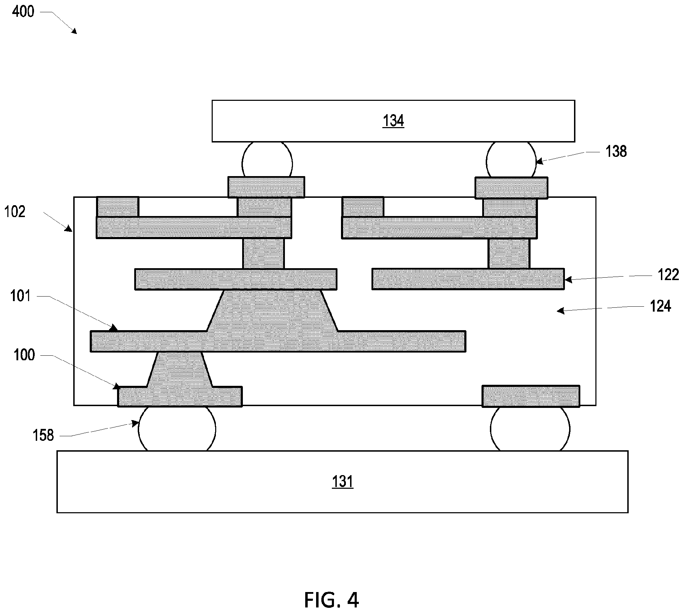

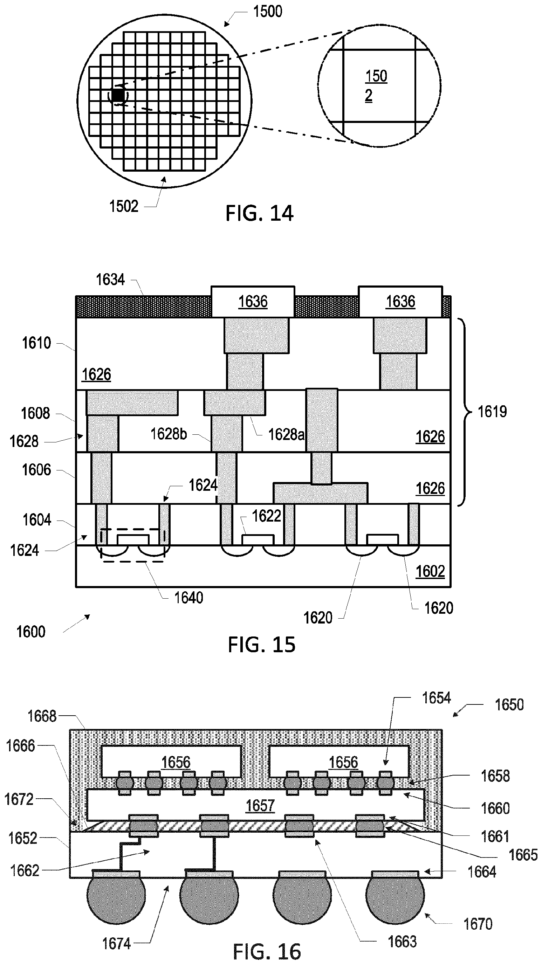

FIGS. 1A-1C are views of a via-pad structure 100, in accordance with various embodiments. FIG. 1A is a top view of an example via-pad structure, FIG. 1B is a side, cross-sectional view along the A-A' line of the example via-pad structure of FIG. 1A, and FIG. 1C is a side, cross-sectional view along the B-B' line of the example via-pad structure of FIG. 1A. As shown in FIG. 1A, the via-pad structure 100 includes a via 115, a pad 119, and a single bridge 117 connecting the via 115 and the pad 119. The via-pad structure 100 may be part of a larger network of conductive pathways 122 through a package support 102 (e.g., as discussed below with reference to FIGS. 4 and 16) or other IC component. In particular, a "vertical" via 115 may contact a "horizontal" pad 119 in different layers of a package support 102 or other IC component. As illustrated in FIG. 1A, the via 115 may be at least partially nested in an aperture or opening 107 in the pad 119. The via 115 may be aligned such that a centerpoint of the via 115 may be aligned with a centerpoint of the pad 119 where the via 115 may be separated from the pad 119 by a gap 118. Such a via-pad structure 100 may be referred to as a "zero misalignment" structure. The terms "gap" and "channel" may be used interchangeably herein. In some embodiments, the centerpoint of the via 115 may not be aligned with the centerpoint of the pad 119 and instead the alignment of the via 115 and the pad 119 in a via-pad structure 100 may be determined by reference to another reference point of the via 115 and the pad 119. In some embodiments, the via 115 may be centered in the opening 107 in the pad 119, as shown in FIG. 1A, such that the gap 118 between the via 115 and the pad 119 has a same dimension along the perimeter of the via 115. In some embodiments, the via 115 may not be centered in the opening 107 in the pad 119 but may be offset (not shown) such that the gap 118 between the via 115 and the pad 119 has different dimensions at different points along the perimeter of the via 115. Although FIG. 1A depicts the via 115 and the pad 119 having a circular footprint (e.g., a circular cross-section), the via 115 and/or the pad 119 may have a non-circular footprint. For example, the via 115 and/or pad 119 may have a cross-section that is rectangular, triangular, oval, elliptical, or oblong, among others. Although FIG. 1A shows the via 115, the opening 107, and the pad 119 having a same shape or cross-section (e.g., circular), the via 115, the opening 107, and the pad 119 may have any suitable shape and cross-section, including different shapes and cross-sections. For example, the via 115 may have a square cross-section, the opening 107 may have a circular cross section, and the pad 119 may have a rectangular cross-section. As shown in FIG. 1B, the via 115 may be connected to the pad 119 by a bridge 117 with a non-linear profile that forms an angle 113 that is greater than 90 degrees where the bridge 117 connects to the pad 119. As shown in FIGS. 1B and 1C, in regions where the via 115 is not connected to the pad 119 by a bridge 117, the via 115 is nested in the pad 119 and is separated from the pad 119 by a gap 118. The dimensions of the via-pad structures 100 may take any suitable values. For example, in some embodiments, a diameter (e.g., width or y-dimension) of a via 115 may be between 1 micron and 50 microns. In some embodiments, a width (e.g., y-dimension) of a pad may be between 10 microns and 250 microns. As shown in FIGS. 1B and 1C, the via 115 may have a greater thickness (e.g., z-height) than the pad 119. In some embodiments, a thickness of the via 115 may be between 4 microns and 40 microns (e.g., between 4 microns and 20 microns, or between 4 microns and 30 microns). In some embodiments, a thickness of the pad 119 may be between 2 microns and 20 microns (e.g., between 2 microns and 10 microns).

A via-pad structure 100 may include more than one bridge 117. FIGS. 2A-2D are views of via-pad structures 100 having multiple bridges 117, in accordance with various embodiments. FIGS. 2A and 2B are top views of example via-pad structures, FIG. 2C is a side, cross-sectional view along the C-C' line of the example via-pad structures of FIGS. 2A and 2B, and FIG. 2D is a side, cross-sectional view along the D-D' line of the example via-pad structures of FIGS. 2A and 2B. As shown in FIG. 2A, the via-pad structure 100 includes a via 115, a pad 119, and a four bridges 117-1, 117-2, 117-3, 117-4 connecting the via 115 and the pad 119. As shown in FIG. 2B, the via-pad structure 100 includes a via 115, a pad 119, and a six bridges 117-1, 117-2, 117-3, 117-4, 117-5, 117-6 connecting the via 115 and the pad 119. As shown in FIG. 2C, the via 115 may be connected to the pad 119 by a first bridge 117-1 and a second bridge 117-2, where the first and second bridges 117-1, 117-2 have non-linear profiles that form angles 113-1, 113-2, respectively, that are greater than 90 degrees where the bridge 117-1, 117-2 connects to the pad 119. The first and second bridges 117-1, 117-2 form a via 115 having a tapered profile. As shown in FIG. 2D, in regions where the via 115 is not connected to the pad 119 by a bridge 117, the via 115 is nested in the pad 119 and is separated from the pad 119 by a gap 118. Although FIGS. 1A, 2A, and 2B show via-pad structures 100 having a particular number of bridges 117, a via-pad structure 100 may include any suitable number of bridges 117, including one, more than one, and more than 10. Although FIGS. 1A, 2A, and 2B show via-pad structures 100 having a single via, a via-pad structure 100 may include any suitable number of vias 115, including one, tow, or more than two.

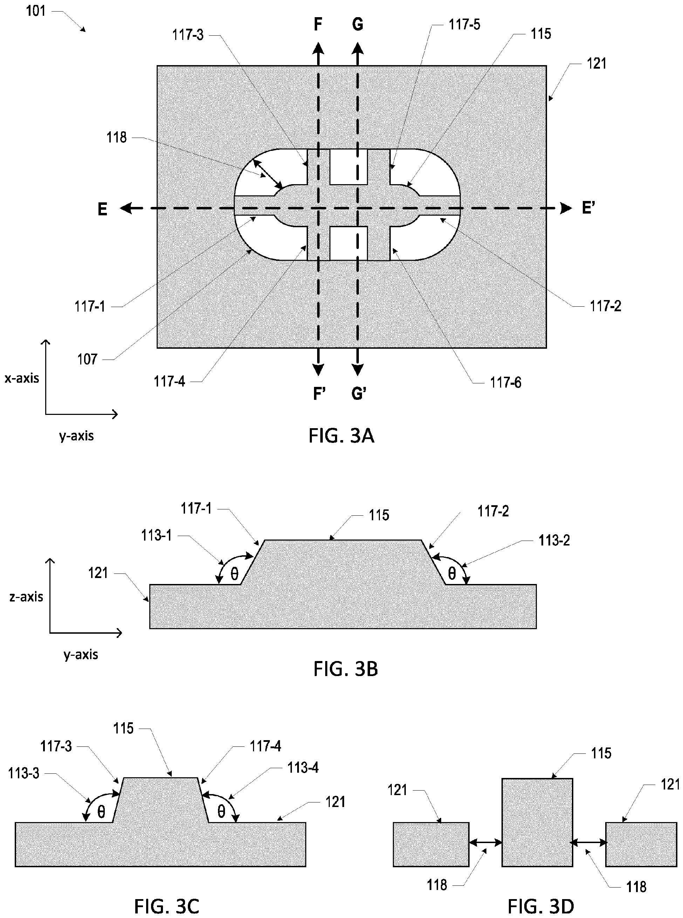

FIGS. 3A-3D are views of a via-plane structure 101, in accordance with various embodiments. FIG. 3A is a top view of an example via-plane structure, FIG. 3B a side, cross-sectional view along the E-E' line of the example via-plane structure of FIG. 3A, FIG. 3C is a side, cross-sectional view along the F-F' line of the example via-plane structure of FIG. 3A, and FIG. 3D is a side, cross-sectional view along the G-G' line of the example via-plane structure of FIG. 3A. As shown in FIG. 3A, the via-pad structure 101 includes a via 115, a plane 121, and a six bridges 117-1, 117-2, 117-3, 117-4, 117-5, 117-6 connecting the via 115 and the plane 121. The via-plane structure 101 may be part of a larger network of conductive pathways 122 through a package support 102 (e.g., as discussed below with reference to FIGS. 4 and 16) or other IC component. In particular, a "vertical" via 115 may contact a "horizontal" plane 121 in different layers of a package support 102 or other IC component. The via 115 may be at least partially nested in an aperture or opening 107 in the plane 121. The via 115 may be nested in the opening 107 in the plane 121 and may be separated from the plane 121 by a gap 118. In some embodiments, the via 115 may be centered in the opening 107 in the plane 121 such that the gap 118 between the via 115 and the plane 121 may have a same dimension along the perimeter of the via 115. In some embodiments, the via 115 may not be centered in the opening 107 in the plane 121 but may be offset (not shown) such that a dimension of the gap 118 between the via 115 and the plane 121 may vary along the perimeter of the via 115. Although FIG. 3A depicts the via 115 having an oblong oval shape (e.g., pill shape), the via 115 may have any suitable size and shape. For example, the via 115 may have a shape that is circular, rectangular, oval, or elliptical, among others. Although FIG. 3A shows the via 115, the opening 107 and the plane 121 having a particular shape and cross-section, the via 115, the opening 107, and the plane 121 may have any suitable shape and cross-section, including different shapes and cross-sections. For example, the via 115 may have a circular cross-section, the opening 107 may have a square cross-section, and the pad 119 may have a rectangular cross-section. As shown in FIG. 3B, the via 115 may be connected to the plane 121 by a first bridge 117-1 and a second bridge 117-2, where the first and second bridges 117-1, 117-2 have non-linear profiles that form angles 113-1, 113-2 that are greater than 90 degrees where the bridges 117-1, 117-2 connect to the plane 121. The first and second bridges 117-1, 117-2 form a via 115 having a first tapered profile. As shown in FIG. 3C, the via 115 may be connected to the plane 121 by a third bridge 117-3 and a fourth bridge 117-4, where the third and fourth bridges 117-3, 117-4 have non-linear profiles that form angles 113-3, 113-4 that are greater than 90 degrees where the bridges 117-3, 117-4 connect to the plane 121. The third and fourth bridges 117-3, 117-4 form a via 115 having a second tapered profile. The fist tapered profile may be the same as the second tapered profile or may be different than the second tapered profile. The angles 113-1, 113-2, 113-3, 113-4 may be a same angle or may be different angles, but all angles will be greater than 90 degrees. As shown in FIG. 3D, in regions where the via 115 is not connected to the plane 121 by a bridge 117, the via 115 is nested in the plane 121 and is separated from the plane 121 by a gap 118. The dimensions of the via-pad structures 100 may take any suitable values. As shown in FIGS. 3B-3D, the via 115 may have a greater thickness (e.g., z-height) than the plane 121. In some embodiments, a thickness of the via 115 may be between 4 microns and 40 microns(e.g., between 4 microns and 20 microns, or between 10 microns and 30 microns). In some embodiments, a thickness of the plane 121 may be between 2 microns and 20 microns (e.g., between 2 microns and 10 microns, or between 5 microns and 15 microns).

The via-pad structures 100 and the via-plane structures 101 disclosed herein may include a conductive material (e.g., a metal, such as copper). In some embodiments, the via-pad structures 100 and the via-plane structures 101 may include multiple different conductive materials. In some embodiments, the via-pad structures 100 and the via-plane structures 101 may be surrounded by a dielectric material 124 (discussed below with reference to FIG. 4); the via-pad structures 100 and the via-plane structures 101 may include or may be in contact with various liner materials (e.g., a diffusion liner to limit diffusion of the conductive material of the via-pad structures 100 and the via-plane structures 101 into the surrounding dielectric material 124, and/or an adhesion liner to improve mechanical coupling between the via-pad structures 100 and the via-plane structures 101 and the surrounding dielectric material 124). Although FIG. 3A shows a via-plane structure 101 having a particular number and arrangement of bridges 117, a via-plane structure 101 may include any suitable number and arrangement of bridges 117, including one bridge, more than one bridge, and more than 10 bridges. Although FIG. 3A shows a via-plane structure 101 having a particular number and arrangement of vias 115, a via-plane structure 101 may include any suitable number of vias 115, including one, two, or more than two.

FIG. 4 is a cross-sectional view of an example microelectronic assembly 400 including a via-pad structure and a via plane structure, in accordance with various embodiments. The microelectronic assembly 400 may include a package support 102 (e.g., a package substrate or an interposer) having a via-pad structure 100 and a via-plane structure 101. The package support 102 may further include conductive pathways 122 (e.g., lines and vias) through one or more layers of dielectric material 124. The via-pad structure 100 and the via-plane structure 101 may be through a layer of dielectric material 124 and may be part of the conductive pathways 122. The package support 102 may be any suitable substrate and may be made of any suitable material, including, for example, an organic substrate. In some embodiments, the package support 102 is a package substrate that may include an insulating material (e.g., a dielectric material formed in multiple layers, as known in the art) and one or more conductive pathways through the dielectric material (e.g., including conductive traces and/or conductive vias, as shown). In some embodiments, the insulating material of the package substrate may be a dielectric material, such as an organic dielectric material, a fire retardant grade 4 material (FR-4), BT resin, polyimide materials, glass reinforced epoxy matrix materials, or low-k and ultra low-k dielectric (e.g., carbon-doped dielectrics, fluorine-doped dielectrics, porous dielectrics, and organic polymeric dielectrics). In some embodiments, the package support 102 may include a liquid crystal polymer, benzocyclobutene (BCB), polyimide, epoxy, or any combination thereof. In some embodiments, the package support 102 may include inorganic fillers, such as silica. In some embodiments, the package support 102 may include silicon, III-V, or a combination of these materials. In some embodiments, the package support 102 is a multi-chip package substrate. In some embodiments, the package support 102 is a system-in-package (SiP) substrate. In some embodiments, the package support 102 is an interposer substrate. In some embodiments, the package support 102 may include electronic devices, for example, transistors, memories, capacitors, inductors, resistors, optoelectronic devices, switches, and any other active and passive electronic devices that are separated by an electrically insulating layer, for example, an interlayer dielectric, a trench insulation layer, or any other insulating layer. The microelectronic assembly 400 may further include a die 134 coupled to the package support 102 by first-level interconnects (FLI) 138. The microelectronic assembly 400 may further include a circuit board (e.g., a mother board) coupled to the package support 102 by second-level interconnects (SLI) 158. The conductive pathways 122, including the via-pad structure 100 and the via-plane structure 101, may carry signals between the die 134 and the circuit board 131, or may connect to a power plane or a ground plane. Although FIG. 4 shows a package support 102 having a particular number and arrangement of via-pad structures and via plane structures, a package support 102 may have any suitable number and arrangement of via-pad structures and/or a via plane structures. Although FIG. shows a single die 134, the microelectronic assembly 400 may have any suitable number of dies. In some embodiments, the die 134 may be an active or passive die that may include IO circuitry, high-bandwidth memory, or enhanced dynamic random access memory (EDRAM). For example, die 134 may include a processor (e.g., including transistors, arithmetic logic units, and other components) that may include a central processing unit (CPU), a graphics processing unit (GPU), or both. In some embodiments, microelectronic assemblies disclosed herein may include a plurality of dies coupled to the package substrate or coupled to another die in a package-on-package (PoP) configuration. In some embodiments, the microelectronic assembly 400 may serve as a SiP in which multiple dies having different functionality are included. In such embodiments, the microelectronic assembly may be referred to as an SiP.

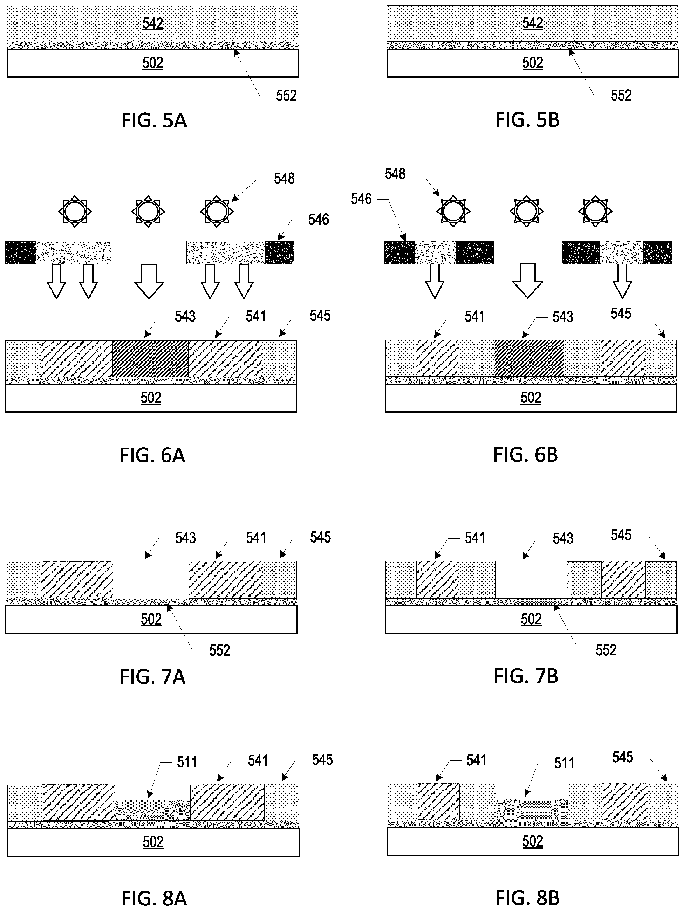

The via-pad structures 100 and via-plane structures 101 disclosed herein may be manufactured using any suitable techniques. For example, FIGS. 5-12 provide various views of stages in an example process of manufacturing a via-pad structure 100 or a via-plane structure 101, in accordance with various embodiments. In FIGS. 5-12, the "A" sub-figures of FIGS. 5-12 represent side, cross-sectional views along two bridge portions (e.g., analogous to FIG. 2C, 3B, and 3C) and the "B" sub-figures of FIGS. 5-12 represent side, cross-sectional views along non-bridge portions (e.g., analogous to FIGS. 2D and 3D). The process illustrated in FIGS. 5-12 may be a semi-additive process. Further, the process illustrated in FIGS. 5-12 may involve the lithographic patterning of the via-pad structure 100 or the via-plane structure 101 using a single mask to achieve zero misalignment.

FIG. 5 illustrates an assembly including a carrier 502 subsequent to depositing a seed layer 552 and a layer of photoresist 542 on the carrier 502. The seed layer 552 may be any suitable conductive material, including copper or a bilayer of titanium and copper. The seed layer 552 may be formed by depositing conductive material using any suitable technique, including, for example, electroplating, sputtering, electroless plating, chemical vapor deposition (CVD), metalorganic chemical vapor deposition (MOCVD), or atomic layer deposition (ALD). The carrier 502 may be of any suitable material, such as stainless steel, glass, silicon, fiber-glass reinforced epoxy, polyethylene terephthalate (PET), among others, and may be attached to the subassembly using any suitable means that may allow for removal at the end of the process, for example, an adhesive or an ultraviolet (UV) active release film. The adhesive or UV release film may be deposited using any suitable process, including lamination, slit coating, spin coating, or spray coating, among others. In some embodiments, the carrier 502 may be a substrate on which the via-pad 100 and/or via-plane structures 101 are formed. The photoresist 542 may include any suitable photoresist, such as a spin-on or laminated photoresist. In some embodiments, the photoresist 542 may be a dry film resist.

FIG. 6 illustrates an assembly undergoing a lithographic operation in which the photoresist 542 of the assembly of FIG. 5 is exposed with a single grayscale mask 546 to simultaneously expose different areas of the photoresist 542 to different amounts ("doses") of electromagnetic energy 548. In particular, a first exposure dose area 543 may be exposed to a first dose of electromagnetic energy (e.g., the "white" area of the grayscale mask 546), a second exposure dose area 541 may be exposed to a second dose of electromagnetic energy different from the first dose (e.g., the "gray" area of the grayscale mask 546), and a third exposure dose area 545 may be exposed to a third dose of electromagnetic energy different from the first and second doses (e.g., the "black" area of the grayscale mask 546). The magnitude of the second dose may be between the magnitude of the first dose and the magnitude of the third dose, so that the first exposure dose area 543 is most readily removed during development, the second exposure dose area 541 is next most readily removed during development, and the third exposure dose area 545 is least readily removed during development. In some embodiments, the photoresist 542 may be a negative-type resist in which unexposed (or less exposed) areas of the photoresist 542 may be more readily removed during subsequent development; in some such embodiments, the first dose of electromagnetic energy may be an approximately zero dose (e.g., the grayscale mask may be "black" in the area corresponding to the first exposure dose area 543). In some embodiments, the photoresist 542 may be a positive-type resist in which more heavily exposed areas of the photoresist 542 may be more readily removed during subsequent development; in some such embodiments, the third dose of electromagnetic energy may be an approximately zero dose (e.g., the grayscale mask 546 may be "black" in the area corresponding to the third exposure dose area 545). Using a single grayscale mask to pattern the photoresist 542 into the exposure dose areas 543/541/545 may ensure that these exposure dose areas are aligned with each other in a desired manner; such alignment may not be achievable using conventional techniques in which vias and traces are separately patterned (e.g., using multiple masks).

FIG. 7 illustrates an assembly subsequent to developing the exposed photoresist of the assembly of FIG. 6 so as to remove the first exposure dose area 543. In some embodiments, this development operation may be a "fast" develop so that only the first exposure dose area 543 (the most readily removed) is removed, and the second exposure dose area 541 and the third exposure dose area 545 remain. The removal of the first exposure dose area 543 may uncover portions of a surface of the seed layer 552.

FIG. 8 illustrates an assembly subsequent to depositing a first conductive material 511 in the opening formed by removal of the first exposure dose area 543 The conductive material 511 may be deposited to a desired thickness using any suitable technique. In some embodiments, the first conductive material 511 may form a portion of a via (e.g., a via 115). In some embodiments, the conductive material 511 may be deposited by a plating operation (e.g., electroplating or electroless plating).

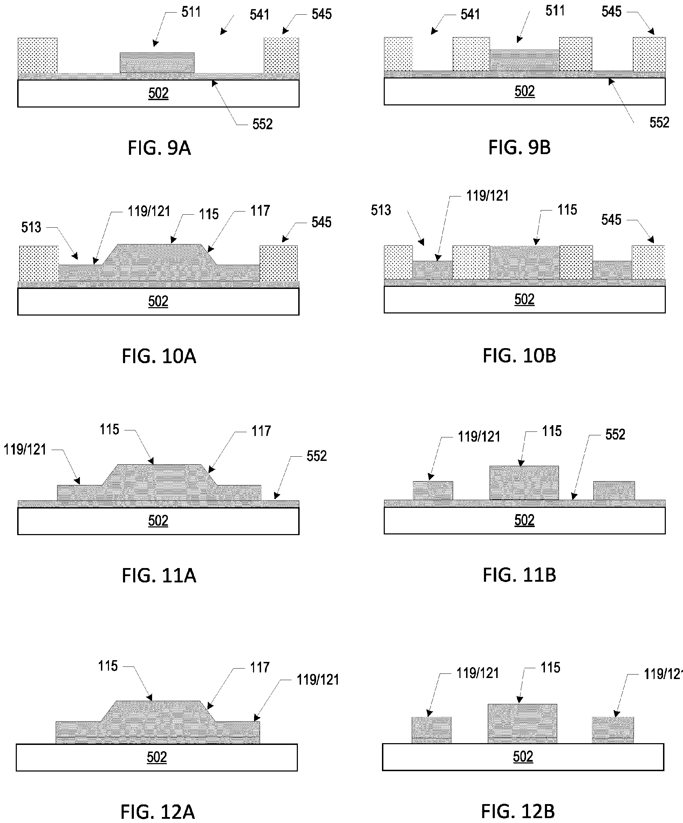

FIG. 9 illustrates an assembly subsequent to developing the exposed photoresist of the assembly of FIG. 8 so as to remove the second exposure dose area 541. In some embodiments, this development operation may be "slower" than the develop operation discussed above with reference to FIG. 6 so that only the second exposure dose area 541 (more readily removed than the third exposure dose area 545) is removed; the third exposure dose area 545 may remain in the assembly, as shown. The removal of the second exposure dose area 541 may uncover further portions of the surface of the seed layer 552.

FIG. 10 illustrates an assembly subsequent to depositing a second conductive material 513 in the openings formed by removal of the first and second exposure dose areas 543, 541. The second conductive material 513 may be deposited to a desired thickness using any suitable technique. The second conductive material 513 may be deposited over the first conductive material 511 and may form a via 115, a pad 119 or plane 121, and at least two bridges 117 connecting the via 115 to the pad 119 or plane 121. In some embodiments, the second conductive material 513 may be deposited by a plating operation (e.g., electroplating or electroless plating).

FIG. 11 illustrates an assembly subsequent to removing the photoresist from the third exposure dose area 545. The removal of the third exposure dose area 545 may uncover further portions of the surface of the seed layer 552.

FIG. 12 illustrates an assembly subsequent to removing portions of the seed layer 552 using a seed etching process. Further operations may be performed on the assembly of FIG. 12, for example, a layer of dielectric material may be formed on and over the assembly using any suitable process, such as lamination or slit coating and curing. Additional layers of conductive structures may be formed and the carrier 502 may be removed.

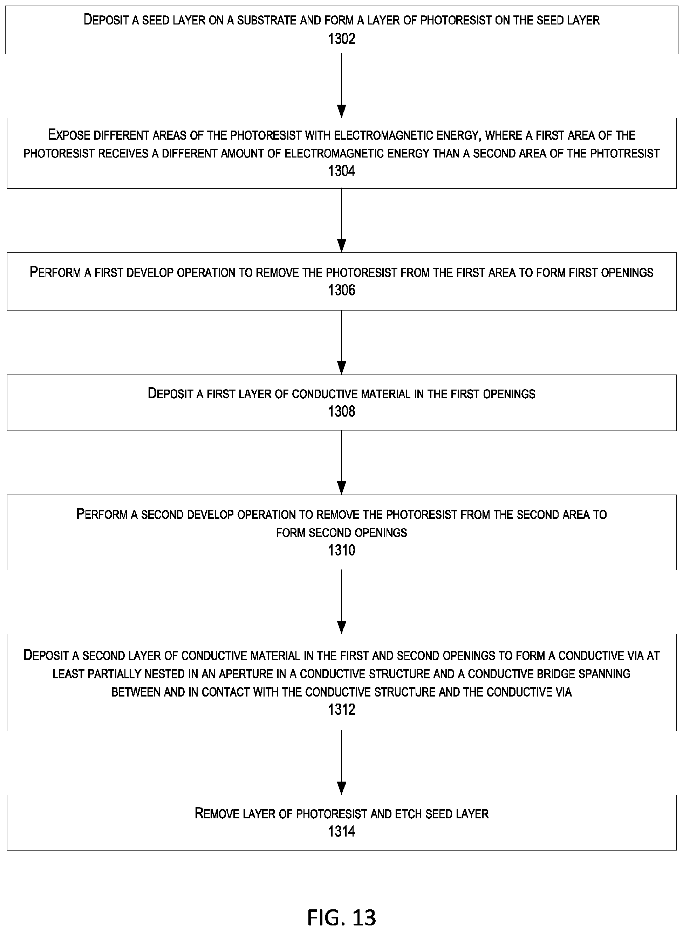

FIG. 13 is a flow diagram of a method of manufacturing a via-pad structure or a via-plane structure, in accordance with various embodiments. At 1302, a seed layer and a layer of photoresist may be formed on a carrier or a substrate. At 1304, different areas of the photoresist may be exposed to different levels electromagnetic energy. For example, a grayscale mask may be used such that a first area of the photoresist may receive a different amount of electromagnetic energy than a second area of the photoresist. At 1306, a first develop operation may be performed to remove the photoresist from the first area to form first openings. At 1308, a first layer of conductive material may be deposited in the first openings. The conductive material may be deposited using any suitable process, such as electroplating. At 1310, a second develop operation may be performed to remove the photoresist from the second area to form second openings. At 1312, a second layer of conductive material may be deposited in the first openings and the second openings to form a conductive via at least partially nested in an opening in a conductive structure (e.g., a via-pad or a via-plane structure) and a conductive bridge spanning between and in contact with the conductive structure and the conductive via. At 1314, any remaining photoresist may be removed and the exposed seed layer may be removed using a seed etch process.

The IC package supports 102 disclosed herein may be included in any suitable electronic component. FIGS. 14-18 illustrate various examples of apparatuses that may include any of the IC package supports 102 disclosed herein, or may be included in an IC package that also includes any of the IC package supports 102 disclosed herein.

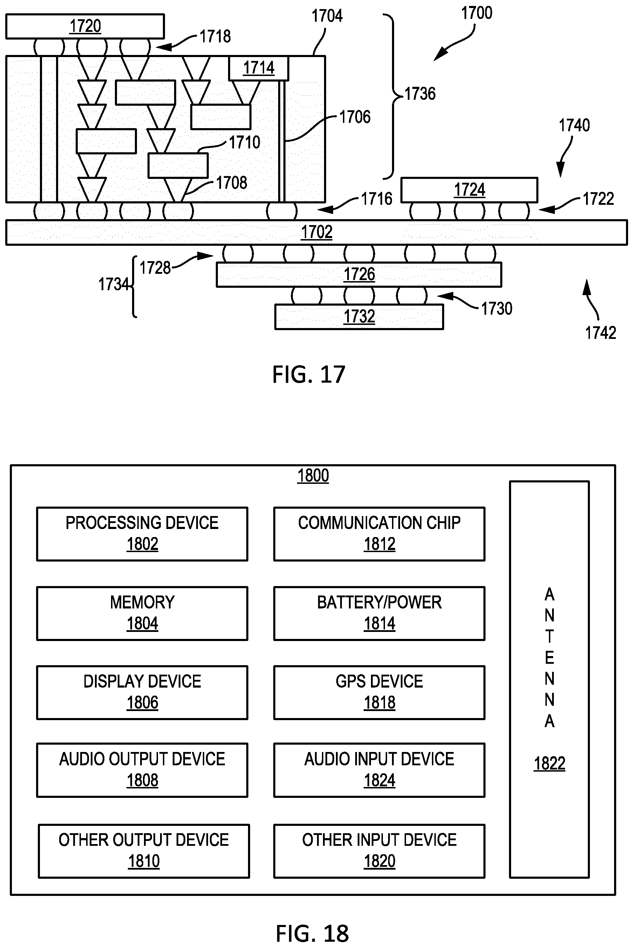

FIG. 14 is a top view of a wafer 1500 and dies 1502 that may be included in an IC package including one or more IC package supports 102 (e.g., as discussed below with reference to FIG. 16) in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 15, discussed below) and/or supporting circuitry to route electrical signals to the transistors, as well as any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 18) or other logic that is configured to store information in the memory devices or execute instructions stored in the memory array.

FIG. 15 is a side, cross-sectional view of an IC device 1600 that may be included in an IC package including one or more IC package supports 102 (e.g., as discussed below with reference to FIG. 16), in accordance with any of the embodiments disclosed herein. One or more of the IC devices 1600 may be included in one or more dies 1502 (FIG. 14). The IC device 1600 may be formed on a substrate 1602 (e.g., the wafer 1500 of FIG. 14) and may be included in a die (e.g., the die 1502 of FIG. 14). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 14) or a wafer (e.g., the wafer 1500 of FIG. 14).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 15 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an 164/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form cavities at the locations of the S/D regions 1620. An epitaxial deposition process may then be carried out to fill the cavities with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 15 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 15). Although a particular number of interconnect layers 1606-1610 is depicted in FIG. 15, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 15. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 15. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 15, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

FIG. 16 is a side, cross-sectional view of an example IC package 1650 that may include one or more IC package supports 102, in accordance with any of the embodiments disclosed herein. For example, the package substrate 1652 and/or the interposer 1657 may be an IC package support 102, in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, etc.), and may have conductive pathways extending through the dielectric material between the surface 1672 and the surface 1674, or between different locations on the surface 1672, and/or between different locations on the surface 1674. These conductive pathways may take the form of any of the interconnects 1628 discussed above with reference to FIG. 15.

The package substrate 1652 may include conductive contacts 1663 that are coupled to conductive pathways 1662 through the package substrate 1652, allowing circuitry within the dies 1656 and/or the interposer 1657 to electrically couple to various ones of the conductive contacts 1664 (or to other devices included in the package substrate 1652, not shown). In embodiments in which the package substrate 1652 is an IC package support 102, the conductive contacts 1663 may be the conductive contacts 152, and the conductive contacts 1664 may be the conductive contacts 154.

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 16 are solder bumps, but any suitable first-level interconnects 1665 may be used. In embodiments in which the interposer 1657 is an IC package support 102, the conductive contacts 1660 may be the conductive contacts 152, and the conductive contacts 1661 may be the conductive contacts 154. In some embodiments, no interposer 1657 may be included in the IC package 1650; instead, the dies 1656 may be coupled directly to the conductive contacts 1663 at the surface 1672 by first-level interconnects 1665.

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 16 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 16 are solder balls (e.g., for a BGA arrangement), but any suitable second-level interconnects 16770 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 17.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high bandwidth memory).

Although the IC package 1650 illustrated in FIG. 16 is a flip chip package, other package architectures may be used. For example, the IC package 1650 may be a BGA package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 16, an IC package 1650 may include any desired number of dies 1656. An IC package 1650 may include additional passive components, such as surface-mount resistors, capacitors, and inductors disposed on the first surface 1672 or the second surface 1674 of the package substrate 1652, or on either surface of the interposer 1657. More generally, an IC package 1650 may include any other active or passive components known in the art.

FIG. 17 is a side, cross-sectional view of an IC device assembly 1700 that may include one or more IC package supports 102, in accordance with any of the embodiments disclosed herein. The IC device assembly 1700 includes a number of components disposed on a circuit board 1702 (which may be, e.g., a motherboard). The IC device assembly 1700 includes components disposed on a first surface 1740 of the circuit board 1702 and an opposing second surface 1742 of the circuit board 1702; generally, components may be disposed on one or both surfaces 1740 and 1742. Any of the IC packages discussed below with reference to the IC device assembly 1700 may take the form of any of the embodiments of the IC package 1650 discussed above with reference to FIG. 16 (e.g., may include one or more IC package supports 102 as a package substrate 1652 or an interposer 1657).

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 17 includes a package-on-interposer structure 1736 coupled to the first surface 1740 of the circuit board 1702 by coupling components 1716. The coupling components 1716 may electrically and mechanically couple the package-on-interposer structure 1736 to the circuit board 1702, and may include solder balls (as shown in FIG. 17), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 17, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 14), an IC device (e.g., the IC device 1600 of FIG. 15), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 17, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal interconnects 1708 and vias 1710, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first surface 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 17 includes a package-on-package structure 1734 coupled to the second surface 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 18 is a block diagram of an example electrical device 1800 that may include one or more IC package supports 102, in accordance with any of the embodiments disclosed herein. Any suitable ones of the components of the electrical device 1800 may include one or more of the IC device assemblies 1700, IC packages 1650, IC devices 1600, or dies 1502 disclosed herein. A number of components are illustrated in FIG. 18 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 18, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 is an integrated circuit (IC) package support, including a conductive structure having an aperture; and a conductive via at least partially nested in the aperture in the conductive structure; and a conductive bridge spanning between and in contact with the conductive structure and the conductive via.

Example 2 may include the subject matter of Example 1, and may further specify that the conductive structure is a conductive pad or a conductive plane.

Example 3 may include the subject matter of Example 1 or 2, and may further specify that the conductive bridge connects to the conductive structure at an angle that is greater than 90 degrees.

Example 4 may include the subject matter of any of Examples 1-3, and may further specify that the conductive structure, the conductive via, and the conductive bridge are in a layer of dielectric material.

Example 5 may include the subject matter of Example 4, and may further specify that the dielectric material includes an organic material.

Example 6 may include the subject matter of any of Examples 1-5, and may further specify that the conductive structure and the conductive via include copper.

Example 7 may include the subject matter of any of Examples 1-6, and may further specify that the conductive bridge is one of a plurality of conductive bridges spanning between and in contact with the conductive structure and the conductive via.

Example 8 may include the subject matter of any of Examples 1-7, and may further specify that the aperture in the conductive structure is a first aperture, the conductive via is a first conductive via, and the conductive bridge is a first conductive bridge, and the IC package support and may further include a second conductive via at least partially nested in a second aperture in the conductive structure; and a second conductive bridge spanning between and in contact with the conductive structure and the second conductive via.

Example 9 may include the subject matter of any of Examples 1-8, and may further specify that a cross-section of the conductive via is circular, rectangular, triangular, oval, elliptical, or oblong.

Example 10 is an integrated circuit (IC) package support, including a conductive structure having an aperture; and a conductive via at least partially nested in the aperture in the conductive structure, wherein the conductive via is separated from the conductive structure by a gap; and a conductive bridge spanning the gap and connecting the conductive structure and the conductive via.

Example 11 may include the subject matter of Example 10, and may further specify that the conductive structure is a conductive pad.

Example 12 may include the subject matter of Example 10, and may further specify that the conductive structure is a conductive plane.

Example 13 may include the subject matter of any of Examples 10-12, and may further specify that the conductive bridge connects to the conductive structure at an angle that is greater than 90 degrees.

Example 14 may include the subject matter of any of Examples 10-13, and may further specify that the conductive structure, the conductive via, and the conductive bridge are in a layer of dielectric material.

Example 15 may include the subject matter of Example 14, and may further specify that the dielectric material includes an organic material.

Example 16 may include the subject matter of any of Examples 10-15, and may further specify that the conductive structure and the conductive via include copper.

Example 17 may include the subject matter of any of Examples 10-16, and may further specify that the conductive bridge is one of a plurality of conductive bridges spanning the gap and in contact with the conductive structure and the conductive via.

Example 18 may include the subject matter of any of Examples 10-17, and may further specify that the aperture in the conductive structure is a first aperture, the conductive via is a first conductive via, and the conductive bridge is a first conductive bridge, and the IC package support and may further include a second conductive via at least partially nested in a second aperture in the conductive structure, wherein the second conductive via is separated from the conductive structure by a second gap; and a second conductive bridge spanning the second gap between and in contact with the conductive structure and the second conductive via.

Example 19 may include the subject matter of any of Examples 10-18, and may further specify that a cross-section of the conductive via is circular, rectangular, triangular, oval, elliptical, or oblong.

Example 20 is an electronic assembly, including an integrated circuit (IC) package support, including a conductive via at least partially nested in an aperture in a conductive plane; and a conductive bridge spanning between and in contact with the conductive plane and the conductive via.

Example 21 may include the subject matter of Example 20, and may further specify that the conductive bridge connects to the conductive plane at an angle that is greater than 90 degrees.

Example 22 may include the subject matter of Example 20 or 21, and may further specify that the conductive plane, the conductive via, and the conductive bridge are in a layer of dielectric material.

Example 23 may include the subject matter of Example 22, and may further specify that the dielectric material includes an organic material.

Example 24 may include the subject matter of any of Examples 20-23, and may further specify that the conductive plane and the conductive via include copper.

Example 25 may include the subject matter of any of Examples 20-24, and may further specify that the conductive bridge is one of a plurality of conductive bridges spanning between and in contact with the conductive plane and the conductive via.

Example 26 may include the subject matter of any of Examples 20-25, and may further specify that the aperture in the conductive plane is a first aperture, the conductive via is a first conductive via, and the conductive bridge is a first conductive bridge, and the IC package support and may further include a second conductive via at least partially nested in a second aperture of the conductive plane; and a second conductive bridge spanning between and in contact with the conductive plane and the second conductive via.

Example 27 may include the subject matter of any of Examples 20-26, and may further specify that a cross-section of the conductive via is circular, rectangular, triangular, oval, elliptical, or oblong.

Example 28 may include the subject matter of any of Examples 20-27, and may further specify that the IC package support further includes conductive contacts and the electronic assembly further includes one or more dies coupled to the conductive contacts.

Example 29 may include the subject matter of any of Examples 20-28, and may further specify that the IC package support is included in an IC package, the electronic assembly further includes a circuit board, and the IC package is coupled to the circuit board.

Example 30 is an electronic assembly, including an integrated circuit (IC) package support, including a conductive via at least partially nested in an aperture in a conductive pad, wherein the conductive via is separated from the conductive pad by a gap; and a conductive bridge spanning the gap and connecting the conductive pad and the conductive via.

Example 31 may include the subject matter of Example 30, and may further specify that the conductive bridge connects to the conductive pad at an angle that is greater than 90 degrees.

Example 32 may include the subject matter of Example 30 or 31, and may further specify that the conductive pad, the conductive via, and the conductive bridge are in a layer of dielectric material.

Example 33 may include the subject matter of Example 32, and may further specify that the dielectric material includes an organic material.

Example 34 may include the subject matter of any of Examples 30-33, and may further specify that the conductive pad and the conductive via include copper.

Example 35 may include the subject matter of any of Examples 30-34, and may further specify that the conductive bridge is one of a plurality of conductive bridges spanning the gap and connecting the conductive pad and the conductive via.

Example 36 may include the subject matter of any of Examples 30-35, and may further specify that the aperture in the conductive pad is a first aperture, the conductive via is a first conductive via, and the conductive bridge is a first conductive bridge, and the IC package support and may further include a second conductive via at least partially nested in a second aperture of the conductive pad; and a second conductive bridge spanning the gap and connecting the conductive pad and the second conductive via.

Example 37 may include the subject matter of any of Examples 30-36, and may further specify that a cross-section of the conductive via is circular, rectangular, triangular, oval, elliptical, or oblong.

Example 38 may include the subject matter of any of Examples 30-37, and may further specify that the IC package support further includes conductive contacts and the electronic assembly further includes one or more dies coupled to the conductive contacts.

Example 39 may include the subject matter of any of Examples 30-38, and may further specify that the IC package support is included in an IC package, the electronic assembly further includes a circuit board, and the IC package is coupled to the circuit board.

Example 40 is a method of manufacturing an integrated circuit (IC) package support, including forming a layer of photoresist; differently exposing different areas of the photoresist with electromagnetic energy, wherein a first area of the photoresist receives a different amount of electromagnetic energy than a second area of the photoresist; after differently exposing, performing a first develop operation to remove the photoresist from the first area to form first openings; depositing a first layer of conductive material in the first openings; performing a second develop operation to remove the photoresist from the second area to form second openings; and depositing a second layer of conductive material in the first openings and the second openings to form a conductive via at least partially nested in an aperture in a conductive structure and a conductive bridge spanning between and in contact with the conductive structure and the conductive via.

Example 41 may include the subject matter of Example 40, and may further specify that the conductive structure is a conductive pad or a conductive plane.

Example 42 may include the subject matter of Example 40 or 41, and may further specify that the photoresist is a dry film resist.

Example 43 may include the subject matter of any of Examples 40-42, and may further specify that differently exposing different areas of the photoresist includes using a single grayscale mask to expose the photoresist.

Example 44 may include the subject matter of any of Examples 40-43, and may further specify that differently exposing different areas of the photoresist further includes a third area of the photoresist that receives no electromagnetic energy.

Example 45 may include the subject matter of any of Examples 40-44, and may further include removing the layer of photoresist; and forming a layer of dielectric material over the conductive structure, the conductive via, and the conductive bridge.

Example 46 may include the subject matter of any of Examples 40-45, and may further include depositing a seed layer and forming the layer of photoresist on the seed layer.

## Claims

1. An integrated circuit (IC) package support, comprising:
a conductive structure having an aperture; and
a conductive via at least partially nested in the aperture in the conductive structure; and
a conductive bridge spanning between and in contact with the conductive structure and the conductive via.

2. The IC package support of claim 1, wherein the conductive structure is a conductive pad or a conductive plane.

3. The IC package support of claim 1, wherein the conductive bridge connects to the conductive structure at an angle that is greater than 90 degrees.

4. The IC package support of claim 1, wherein the conductive structure, the conductive via, and the conductive bridge are in a layer of dielectric material.

5. The IC package support of claim 1, wherein the conductive structure is a conductive pad or a conductive plane.

6. The IC package support of claim 1, wherein the conductive bridge is one of a plurality of conductive bridges spanning between and in contact with the conductive structure and the conductive via.

7. The IC package support of any one of claims 1-5, wherein the aperture in the conductive structure is a first aperture, the conductive via is a first conductive via, and the conductive bridge is a first conductive bridge, and the IC package support further comprising:
a second conductive via at least partially nested in a second aperture in the conductive structure; and
a second conductive bridge spanning between and in contact with the conductive structure and the second conductive via.

8. The IC package support of any one of claims 1-5, wherein a cross-section of the conductive via is circular, rectangular, triangular, oval, elliptical, or oblong.

9. An electronic assembly, comprising:
an integrated circuit (IC) package support including:
conductive contacts at a surface of the IC package support;
a conductive pad having an aperture;
a conductive via at least partially nested in the aperture in the conductive pad, wherein the conductive via is separated from the conductive pad by a gap; and
a conductive bridge spanning the gap and connecting the conductive pad and the conductive via; and
a die coupled to the conductive contacts at the surface of the IC package support.

10. The electronic assembly of claim 9, wherein the conductive bridge connects to the conductive pad at an angle that is greater than 90 degrees.

11. The electronic assembly of claim 9, wherein the conductive pad, the conductive via, and the conductive bridge are in a layer of dielectric material.

12. The electronic assembly of any one of claims 9-11, wherein the conductive bridge is one of a plurality of conductive bridges spanning the gap and connecting the conductive pad and the conductive via.

13. The electronic assembly of any one of claims 9-11, wherein the IC package support is included in an IC package, the electronic assembly further includes a circuit board, and the IC package is coupled to the circuit board.

14. A method of manufacturing an integrated circuit (IC) package support, comprising:
forming a layer of photoresist;
differently exposing different areas of the photoresist with electromagnetic energy, wherein a first area of the photoresist receives a different amount of electromagnetic energy than a second area of the photoresist;
after differently exposing, performing a first develop operation to remove the photoresist from the first area to form first openings;
depositing a first layer of conductive material in the first openings;
performing a second develop operation to remove the photoresist from the second area to form second openings; and
depositing a second layer of conductive material in the first openings and the second openings to form a conductive via at least partially nested in an aperture in a conductive structure and a conductive bridge spanning between and in contact with the conductive structure and the conductive via.

15. The method of claim 14, wherein the conductive structure is a conductive pad or a conductive plane.
